# FASCICULE DE BREVET EUROPEEN

(11) **EP 1 147 557 B1**
(45) Date de publication et mention de la délivrance du brevet: **17.10.2007**
(21) Numéro de dépôt: 00900602.4
(22) Date de dépôt: 18.01.2000
(51) Int. Cl.: H01L 23/498, H01L 23/538, G06K 19/077, H01L 23/31

(54) **DISPOSITIF A CIRCUITS INTEGRES, MODULE ELECTRONIQUE POUR CARTE A PUCE UTILISANT LE DISPOSITIF ET PROCEDE DE FABRICATION DUDIT DISPOSITIF**
INTEGRIERTE SCHALTUNGSANORDNUNG, ELEKTRONISCHES MODUL FÜR CHIPKARTE, DAS DIE ANORDNUNG BENUTZT, UND VERFAHREN ZU DEREN HERSTELLUNG
INTEGRATED CIRCUIT DEVICE, ELECTRONIC MODULE FOR CHIP CARD USING SAID DEVICE AND METHOD FOR MAKING SAME

(30) Priorité: 27.01.1999 FR 9900858
(43) Date de publication de la demande: 24.10.2001
(73) Titulaire: Axalto S.A., 92190 Meudon (FR)
(72) Inventeur: REIGNOUX, Yves, F-45380 la Chapelle St Mesmin (FR); DANIEL, Eric, F-45650 Saint Jean le Blanc (FR)
(74) Mandataire: Cassagne, Philippe M.J.
(86) Numéro de dépôt international: PCT/FR2000/000098
(87) Numéro de publication internationale: WO 2000/045434

(56) Documents cités:
- EP-A- 0 508 266
- EP-A- 0 712 159
- US-A- 5 155 068
- US-A- 5 777 391
- US-A- 5 811 877
- PATENT ABSTRACTS OF JAPAN vol. 009, no. 239 (P-391), 25 septembre 1985 (1985-09-25) -& JP 60 091489 A (NIPPON DENSHIN DENWA KOSHA), 22 mai 1985 (1985-05-22)
- PATENT ABSTRACTS OF JAPAN vol. 017, no. 196 (M-1397), 16 avril 1993 (1993-04-16) -& JP 04 341896 A (HITACHI LTD), 27 novembre 1992 (1992-11-27)
- PATENT ABSTRACTS OF JAPAN vol. 016, no. 542 (E-1290), 12 novembre 1992 (1992-11-12) -& JP 04 207061 A (SHINKO ELECTRIC IND CO LTD), 29 juillet 1992 (1992-07-29)
- PATENT ABSTRACTS OF JAPAN vol. 014, no. 132 (M-0948), 13 mars 1990 (1990-03-13) -& JP 02 002095 A (RICOH CO LTD), 8 janvier 1990 (1990-01-08)

## Description

La présente invention a pour objet un dispositif à circuits intégrés, un module électronique pour carte à puce utilisant le dispositif à circuits intégrés et un procédé de fabrication dudit dispositif.

De façon plus précise la présente invention concerne la réalisation d'une pastille semi-conductrice dans laquelle sont réalisés des circuits intégrés, qui présente une architecture telle qu'elle permet la fabrication de modules électroniques pour carte à puce d'épaisseur réduite.

On sait que les cartes à puce utilisées notamment comme carte bancaire, comme carte d'identification, ou encore comme carte de règlement de différentes prestations sont constituées essentiellement par un corps en matériau plastique de forme parallélépipèdique rectangle dans lequel est inséré un module électronique constitué le plus souvent par une pastille semi-conductrice fixée sur un substrat isolant muni de plages externes de contact électrique. Ces plages externes permettent la liaison électrique entre les circuits de la pastille semi-conductrice et les circuits d'un dispositif de lecture-écriture lorsque la carte est introduite dans un tel dispositif.

Selon les normes en vigueur, le corps de la carte doit présenter une épaisseur de l'ordre de 0,8 mm. On comprend que l'épaisseur du module électronique est donc un paramètre critique de celui-ci afin de faciliter l'insertion du module électronique dans le corps de carte et d'assurer la qualité de la liaison mécanique entre le corps de carte et le module ainsi que l'intégrité mécanique du module électronique.

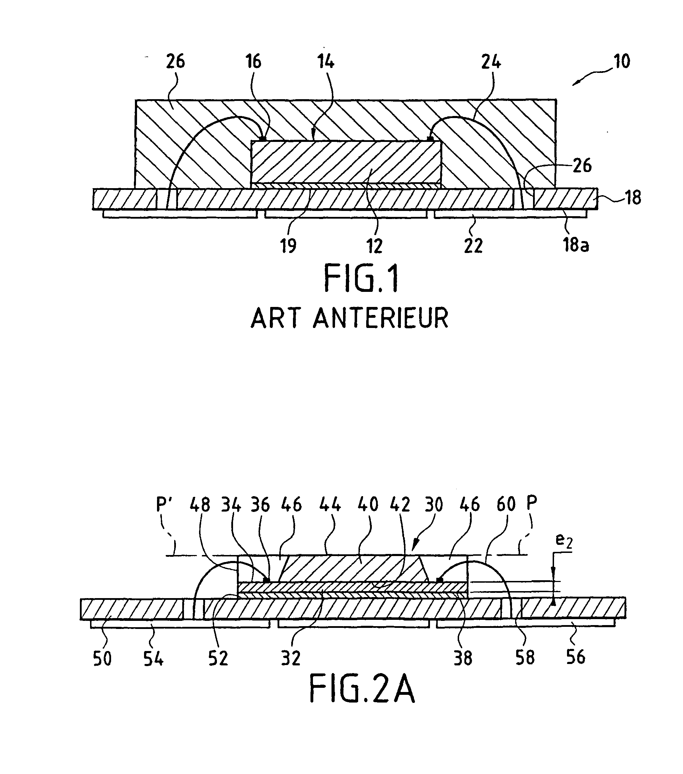

Sur la figure 1 annexée, on a représenté en coupe verticale un module électronique pour carte à puce réalisé selon une technique connue. Le module électronique 10 est constitué essentiellement par une pastille semi-conductrice 12 dans laquelle sont réalisés des circuits intégrés, cette pastille présentant une face active 14 munie de plots de connexion électrique 16. La pastille semi-conductrice 12 est fixée sur un substrat isolant 18 par une couche de colle 19. La face externe 18a du substrat isolant est munie de plages externes de contact électrique 20 destinées à entrer en contact avec les contacts électriques du dispositif de lecture-écriture. Les plots 16 de la pastille 12 sont raccordés aux plages externes 20 par des conducteurs électriques filaires tels que 24. Selon une technique connue, le substrat isolant comporte des fenêtres 26 traversées par les conducteurs électriques 24, ce qui permet d'éviter l'utilisation d'un circuit imprimé double face. Pour assurer l'intégrité électrique de la pastille 12 et des conducteurs électriques 24, on réalise un enrobage 26 en un matériau isolant tel qu'une résine époxy.

Dans certains cas, les conducteurs filaires peuvent être remplacés par d'autres éléments conducteurs électriques de connexion entre les plots de la pastille et les plages externes du substrat isolant.

Avec une telle technologie de fabrication, on obtient un module électronique dont l'épaisseur globale est de l'ordre de 0,6 mm à rapprocher des 0,8 mm qui constituent l'épaisseur du corps de la carte.

Les techniques qui permettraient de réduire cette épaisseur sont d'une mise en oeuvre délicate. Elles pourraient consister à réduire l'épaisseur de la puce qui est de façon standard de l'ordre de 180 µm mais cela risquerait de fragiliser de façon inacceptable la puce On pourrait également réduire l'épaisseur due à la courbure des fils électriques 24 ou des éléments de connexion électrique analogues. Cependant, cela nécessite l'utilisation de la technologie appelée en anglo-saxon "Wedge bonding" qui est d'un coût de mise en oeuvre élevé. Enfin, on pourrait envisager de réduire l'épaisseur de la résine isolante constituant l'enrobage 26. Cependant, cette réduction fragiliserait l'ensemble du module électronique.

Le brevet US 5,155,068 décrit un procédé de fabrication d'un module électronique pour carte à puce. Selon ce procédé une pastille semi-conductrice comprend une face active munie de couches de fils métallique (en anglais : metallic wive layers). Des connexions sont faites entre ces couches de fils métallique et un substrat muni de contacts électriques.. Ensuite, une résine acrylique ou d'époxy est appliquée afin de fixer la pastille semi-conductrice au substrat muni de contacts électriques. Ce procédé a un coût de mise en oeuvre élevé.

Les demandes de brevet JP-A-60 091489, EP-A-0 508 266, JP-A-04 341896, JP-A-04 207061, US-A-5 777 391 et US-A-5 811 877 divulguent des dispositifs similaires.

Un premier objet de la présente invention est de fournir un dispositif à circuits intégrés qui permet la réalisation d'un module électronique pour carte à puce d'épaisseur réduite tout en ne présentant pas les inconvénients des techniques énoncées ci-dessus.

Pour atteindre ce but, selon l'invention, le dispositif à circuits intégrés se caractérise en ce qu'il comprend les caractéristiques techniques de la revendication 1.

Un module électronique pour carte à puce à partir d'un tel dispositif à circuits intégrés est revendiqué dans la revendication 5.

On comprend que grâce à l'épaisseur réduite de la couche active sur la face active de laquelle sont réalisés les plots de contact, ces plots de contact sont proches de la face du dispositif à circuits intégrés qui est fixée sur le substrat isolant lors de la réalisation du module électronique. On comprend également que grâce à la présence des évidements qui débouchent dans la surface latérale de la couche complémentaire, il est possible, lors de la réalisation du module électronique, de prévoir des fils électriques de connexion qui sont intégralement disposés en dessous du plan qui contient la face supérieure de la couche complémentaire. On comprend que l'épaisseur du module électronique qui en résulte est sensiblement réduite par rapport à l'épaisseur d'un module électronique du type décrit précédemment.

L'invention concerne également un procédé de fabrication d'un dispositif à circuit intégrés selon la revendication 7.

On comprend que selon ce procédé, on part d'une couche active dont l'épaisseur est standard c'est-à-dire de l'ordre de 180 µm, cette couche active étant fixée sur la couche complémentaire qui présente elle-même une certaine épaisseur. On obtient ainsi un ensemble dont l'épaisseur est suffisante pour permettre l'usinage de la face non active de la couche active tout en respectant des dimensions globales qui conservent à l'ensemble une résistance mécanique suffisante.

D'autres caractéristiques et avantages de l'invention apparaîtront mieux à la lecture de la description qui suit d'un mode de réalisation de l'invention donné à titre d'exemple non limitatif. La description se réfère aux figures annexées, sur lesquelles :
la figure 1, déjà décrite, montre en coupe verticale un module électronique pour carte à puce de type standard.
Les figures 2a et 2b représentent en coupe verticale deux étapes de réalisation du module électronique selon l'invention ;
la figure 3 est une vue en coupe horizontale du module électronique selon la ligne III-III de la figure 2b ; et
les figures 4a à 4c illustrent les différentes étapes du procédé de fabrication du dispositif à circuits intégrés.

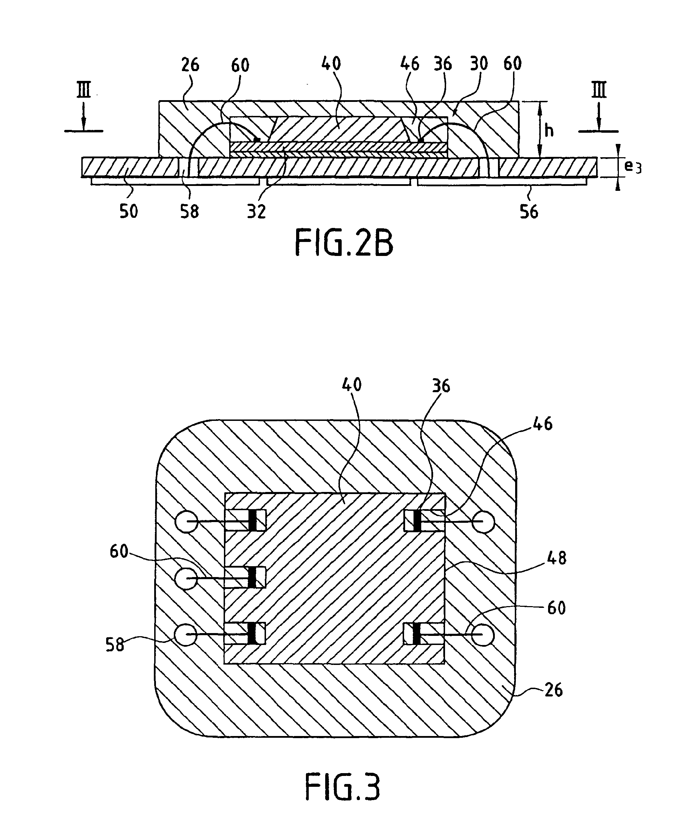

En se référant tout d'abord aux figures 2 et 3, on va décrire le dispositif à circuits intégrés ou puce électronique et le module électronique utilisant cette puce.

Le dispositif à circuits intégrés 30 est constitué essentiellement par une couche active 32 en matériau semi-conducteur typiquement en silicium dans laquelle sont réalisés les différents circuits intégrés. Cette couche active 32 présente une face active 34 dans laquelle sont réalisés les plots de contact électrique 36 et une face de fixation 38. Le dispositif à circuits intégrés 30 comporte également une couche complémentaire 40 dont la première face 42 est fixée par tout moyen convenable, par exemple par une couche intermédiaire de scellement formée d'un polyimide, sur la face active de la couche active 32 et dont la face supérieure 44 est libre. La couche complémentaire 40 peut être avantageusement réalisée également en silicium mais d'autres matériaux présentant des caractéristiques physiques proches de celles du silicium notamment en ce qui concerne son coefficient de dilatation thermique pourraient être utilisés. Une des fonctions de la couche complémentaire 40 est de réaliser une couche de protection contre des tentatives de fraude qui pourraient être réalisées vis-à-vis des circuits intégrés de la couche active.

Comme le montre mieux la figure 3, la couche complémentaire 40 est pourvue d'évidements tels que 46 (dans l'exemple considéré, il y a cinq plots de connexion 36 et cinq évidements 46). Chaque évidement 46 s'étend sur toute l'épaisseur de la couche complémentaire et va du plot de contact 36 jusqu'à la surface latérale 48 de la couche complémentaire 40. En d'autres termes, ces évidements débouchent latéralement dans la couche complémentaire.

Selon le mode de réalisation décrit, l'épaisseur e₁ de la couche complémentaire est égale à 140 µm et l'épaisseur e₂ de la couche active est égale à 40 µm. Ainsi, l'épaisseur totale du dispositif à circuits intégrés est égale à 180 µm ce qui correspond à l'épaisseur d'une pastille semi-conductrice standard.

Plus généralement, l'épaisseur de la couche active est inférieure à 100 µm, cette épaisseur réduite pouvant être obtenue grâce à la mise en oeuvre du procédé de fabrication qui sera décrit ultérieurement. De préférence encore, l'épaisseur e₂ de la couche active est comprise entre 5 et 50 µm.

L'épaisseur de la couche complémentaire est ainsi significativement supérieure à celle de la pastille semi-conductrice. Cela permet en particulier l'obtention d'un module plus fin, les fils conducteurs étant dans un mode préféré de réalisation de l'invention effectivement logés dans l'épaisseur totale de l'ensemble formé par la couche complémentaire et la pastille semi-conductrice constituant la couche active.

La couche complémentaire recouvre complètement la face active de la couche active, sauf, bien entendu, en ce qui concerne les évidements. Plus précisément, la surface de la face active de la couche active est sensiblement égale à la surface de la première face de la couche complémentaire réduite de la surface correspondant aux évidements ménagés dans ladite couche complémentaire. De ce fait, il est possible d'usiner la couche active de manière à l'amincir jusqu'à l'épaisseur voulue. En outre, l'ensemble couche active/couche complémentaire est plus résistant aux contraintes mécaniques qui lui sont imposées, la couche complémentaire protégeant la couche active.

Par ailleurs, on notera qu'il y a avantageusement autant d'évidements que de bornes de connexion dans la pastille semi-conductrice et que ces évidements représentent une portion réduite de la surface totale de la couche complémentaire.

Pour réaliser le module électronique, le dispositif à circuits intégrés 30 est fixé sur un support isolant 50 à l'aide d'une couche de matériau adhésif 52, la face externe 54 du substrat isolant étant munie des plages externes de contact électrique 56. Des fenêtres telles que 58 sont prévues dans le substrat isolant au droit de chacune des plages 56. Un conducteur électrique filaire 60, par exemple en or, est d'une part fixé sur un plot de connexion 36 et d'autre part sur la face postérieure d'une plage externe de contact électrique 56 à travers la fenêtre 58. On comprend que grâce au fait que la couche active 32 est d'épaisseur très réduite, les plots 36 sont proches du substrat isolant 50. Cela permet que l'intégralité du fil conducteur 60 coudé soit disposée en dessous du plan P P' qui contient la face supérieure 44 de la couche complémentaire 40.

Il en serait de même si les fils conducteurs étaient remplacés par des éléments allongés de connexion électrique.

Pour terminer le module électronique, il suffit de réaliser l'enrobage 62 dont l'épaisseur totale h est réduite grâce aux dispositions qui ont été décrites précédemment.

Dans l'exemple de réalisation décrit, l'épaisseur totale h de l'enrobage est égale à 310 µm si l'on tient compte de l'épaisseur de la couche d'adhésif entre le substrat et le dispositif à circuits intégrés. L'épaisseur e₃ du substrat isolant étant typiquement égale à 170 µm, on obtient un module électronique dont l'épaisseur est égale à 480 µm. Cela représente une diminution d'épaisseur, par rapport aux modules électroniques standards très importante.

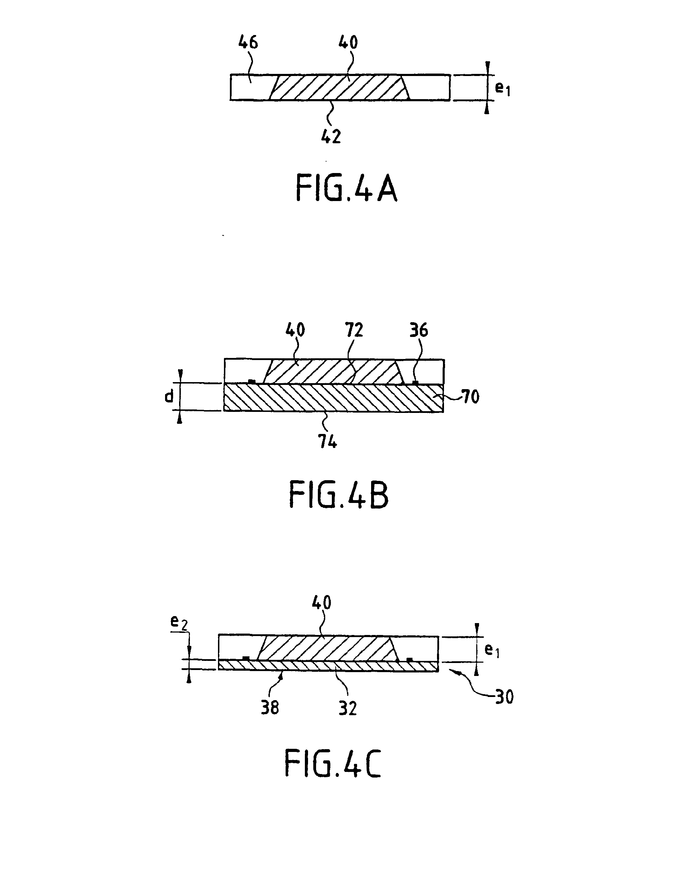

En se référant maintenant aux figures 4A, 4B et 4C, on va décrire les étapes principales de la fabrication du dispositif à circuits intégrés 30.

Dans une première étape illustrée par la figure 4A, on usine, par tout procédé convenable, une plaquette de silicium pour obtenir la couche complémentaire 40 avec ses évidements 46. Cette couche pourrait être réalisée à partir d'un autre matériau. Elle a une épaisseur e₁ qui est de préférence comprise entre 100 et 200 µm.

Puis, dans l'étape illustrée par la figure 4B, on fixe la couche complémentaire 40 sur la face active 72 d'une pastille semi-conductrice 70 équipée des plots de connexion 36. Cette pastille a une épaisseur standard d de l'ordre de 180 µm.

Enfin, dans l'étape illustrée par la figure 4C, on usine, par tout procédé convenable, la face non active 74 de la pastille 70 pour ramener celle-ci à une épaisseur e₂ typiquement égale à 40 µm ce qui donne la couche active 32.

Grâce à la présence de la couche complémentaire 40, le dispositif à circuits intégrés 30 a une épaisseur totale de l'ordre de 180 µm dans l'exemple considéré. On obtient ainsi un composant qui présente une résistance mécanique suffisante bien que la couche active 32 elle-même ait une épaisseur e₂ qui ne lui confère pas ces propriétés de résistance mécanique. Ainsi qu'on l'a déjà expliqué l'intérêt essentiel du composant ainsi obtenu est que les plots de contact 36 sont très proches de la face de fixation 38 du composant.

## Revendications

1. Dispositif à circuits intégrés, comprenant :
- une pastille semi-conductrice (32) formant une couche active dans laquelle sont réalisés les circuits intégrés, la pastille semi-conductrice présentant une face active (34) munie d'une pluralité de plots de connexion électrique (36) et une deuxième face (38), et
- une couche complémentaire (40) présentant une première face (42) fixée sur la face active (34) de la pastille semi-conductrice (32), une deuxième face (44) et une surface latérale (48) définissant le périmètre de la couche complémentaire, **caractérisé en ce que** :
- la pastille semi-conductrice (32) a une épaisseur inférieure à 100 µm,
- la couche complémentaire (40) comporte autant d'évidements (46) crénelés vus en plans qu'il y a de plots de contact sur la pastille semi-conductrice, chaque évidement occupant toute l'épaisseur de la couche complémentaire (40), et s'étendant du droit d'un plot de contact (36) à ladite surface latérale (48),
- la couche complémentaire (40) recouvre complètement la face active (34) de la pastille semi-conductrice, à l'exception des évidements (46) crénelés vus en plan, et **en ce que**
- la couche complémentaire (40) a une épaisseur supérieure à celle de la pastille semi-conductrice (32).

2. Dispositif à circuits intégrés selon la revendication 1, **caractérisé en ce que** l'épaisseur de la pastille semi-conductrice (32) est comprise entre 5 et 50 µm.

3. Dispositif à circuits intégrés selon la revendication 2, **caractérisé en ce que** l'épaisseur de la couche complémentaire (40) est comprise entre 100 et 200 µm.

4. Dispositif à circuits intégrés selon l'une quelconque des revendications 1 à 3, **caractérisé en ce que** la couche complémentaire (40) est réalisée avec le même matériau semi-conducteur que la pastille semi-conductrice (32).

5. Module électronique pour carte à puce, comprenant :
- une pastille semi-conductrice (32) formant une couche active dans laquelle sont réalisés les circuits intégrés, la pastille semi-conductrice (32) présentant une face active (34) munie d'une pluralité de plots de connexion électrique (36) et une deuxième face (38)
- une couche complémentaire (40) présentant une première face (42) fixée sur la face active (34) de la pastille semi-conductrice (32), une deuxième face (44) et une surface latérale (48) définissant le périmètre de la couche complémentaire,
- un substrat isolant (50) présentant une face externe (54) munie de plages externes de contact électrique (56) et une face interne, la deuxième face (38) de la pastille semi-conductrice (32) étant fixée sur la face interne du substrat isolant (50), et
- une pluralité de conducteurs électriques (60), chaque conducteur présentant une première extrémité raccordée à un plot de contact (36) et une deuxième extrémité raccordée à une plage externe de contact (56), **caractérisé en ce que** :
- la pastille semi-conductrice (32) a une épaisseur inférieure à 100 µm,
- la couche complémentaire (40) comporte autant d'évidements (46) crénelés vus en plans qu'il y a de plots de contact sur la pastille semi-conductrice, chaque évidement occupant toute l'épaisseur de la couche complémentaire (40), et s'étendant du droit d'un plot de contact (36) à ladite surface latérale (48),
- la couche complémentaire (40) recouvre complètement la face active (34) de la pastille semi-conductrice, à l'exception des évidements (46) crénelés vus en plan, **en ce que**
- la couche complémentaire (40) a une épaisseur supérieure à celle de la pastille semi-conductrice (32), et **en ce que**
- chaque conducteur électrique (60) est entièrement disposé entre le plan (P-P') contenant la deuxième face (44) de la couche complémentaire (40) et le substrat isolant (50).

6. Module électronique selon la revendication 5, **caractérisé en ce que** le substrat isolant (50) comporte des fenêtres (58), chaque fenêtre (58) étant disposée au droit d'une plage externe de contact électrique (56).

7. Procédé de fabrication d'un dispositif à circuits intégrés selon l'une quelconque des revendications 1 à 4 le procédé comprenant les étapes suivantes :
- une étape de fixage dans laquelle la première face (42) de la couche complémentaire est fixée sur la face active (34) de la pastille semi-conductrice (32), en sorte que chaque évidement (46) de la couche complémentaire s'étend du droit d'un plot de contact (36) de la pastille semi-conductrice (32) à la surface latérale (48) de la couche complémentaire, la couche complémentaire comportant autant d'évidements crénelés vus en plans que de plots de contact sur la pastille semi-conductrice, et ladite couche complémentaire (40) recouvrant complètement la face active (34) de la pastille semi-conductrice, à l'exception des évidements (46) crénelés vus en plan, et
- une étape d'usinage dans laquelle la pastille semi-conductrice (32) est usinée par sa deuxième face (38) pour lui donner une épaisseur inférieure à 100 µm.

## Claims

1. IC device comprising:
- a semiconductor chip (32) making up an active layer in which integrated circuits are made, the semiconductor chip having an active side (34) with a number of electrical bonding terminals (36) and a second side (38) and
- an additional layer (40) with one side (42) fixed to the active side (34) of the semiconductor chip (32) and another side (44) and a lateral surface (48) defining the limits of the additional layer, **characterised in that**:
- the thickness of the semiconductor chip (32) is less than 100 µm,
- the additional layer (40) has as many recesses (46) that are toothed when seen in a plane view as there are bonding terminals on the semiconductor chip, each recess occupying the entire thickness of the additional layer (40) and extending from near a bonding terminal (36) to the said lateral surface (48),
- the additional layer (40) completely covers the active side (34) of the semiconductor chip with the exception of the recesses (46) that are toothed when seen in a plane view, and
- the thickness of the additional layer (40) is greater than that of the semiconductor chip (32).

2. IC device according to claim 1, **characterised in that** the semiconductor chip (32) is 5 to 50 µm thick.

3. IC device according to claim 2, **characterised in that** the additional layer (40) is 100 to 200 µm thick.

4. IC device according to any of claims 1 to 3, **characterised in that** the additional layer (40) is made of the same semiconductor material as the semiconductor chip (32).

5. IC module for chip cards, including:
- a semiconductor chip (32) forming an active layer in which integrated circuits are made, which semiconductor chip (32) has an active side (34) with a number of electrical bonding terminals (36) and a second side (38)
- an additional layer (40) with one side (42) fixed to the active side (34) of the semiconductor chip (32), a second side (44) and a lateral surface (48) defining the limits of the additional layer,
- an insulating substrate (50) with an external side (54) with external electrical bonding pads (56) and an internal side, the second side (38) of the semiconductor chip (32) being fixed to the internal side of the insulating substrate (50) and
- a number of electrical conductors (60), each conductor having one end connected to a bonding terminal (36) and a second end connected to an external contact pad (56) **characterised in that**:
- the semiconductor chip (32) is less than 100 µm thick,
- the additional layer (40) has as many recesses (46) that are toothed when seen in a plane view as there are bonding terminals on the semiconductor chip, each recess occupying the entire thickness of the additional layer (40) and extending from near the bonding terminal (36) to the said lateral surface (48),
- the additional layer (40) completely covers the active side (34) on the semiconductor chip with the exception of recesses (46) that are toothed when seen in a plane view, **in that**
- the additional layer (40) is thicker than the semiconductor chip (32), and **in that**
- each electrical conductor (60) is entirely placed between the plane (P-P') containing the second side (44) of the additional layer (40) and the insulating substrate (50).

6. IC module according to claim 5, **characterised in that** the insulating substrate (50) has windows (58), each window (58) being placed near an external electrical contact terminal (56).

7. IC device manufacturing process according to any claim from 1 to 4, where the process includes the following stages:
- one fixing stage where the first side (42) of the additional layer is fixed to the active side (34) of the semiconductor chip (32) so that each recess (46) of the additional layer extends from a bonding terminal (36) of the semiconductor chip (32) to the lateral surface (48) of the additional layer, where the additional layer has as many recesses that are toothed when seen in a plane view as bonding terminals on the semiconductor chip and the said additional layer (40) completely covers the active side (34) of the semiconductor chip with the exception of the recesses (46) that are toothed when seen in a plane view and
- a machining stage where the semiconductor chip (32) is machined from its second side (38) to give it a thickness below 100 µm.

## Patentansprüche

1. Vorrichtung mit integrierten Schaltungen mit:
- einem Halbleiterplättchen (32), das eine aktive Schicht bildet, in welche die integrierten Schaltungen eingebracht sind, wobei das Halbleiterplättchen eine aktive Seite (34) mit mehreren elektrischen Verbindungsstiften (36) und eine zweite Seite (38) umfasst, und
- einer Zusatzschicht (40) mit einer ersten Seite (42), die auf der aktiven Seite (34) des Halbleiterplättchens (32) befestigt ist, einer zweiten Seite (44) und einer seitlichen Fläche (48), die den Umfang der Zusatzschicht bestimmt, **dadurch gekennzeichnet, dass**:
- das Halbleiterplättchen (32) eine Stärke unter 100 µm aufweist.
- die Zusatzschicht (40) so viele in der Draufsicht gezahnte Aussparungen (46) umfasst, wie Kontaktstifte auf dem Halbleiterplättchen vorhanden sind, wobei jede Aussparung die ganze Stärke der Zusatzschicht (40) einnimmt und sich über das Volumen senkrecht über einem Kontaktstift (36) bis zur besagten seitlichen Fläche (48) erstreckt.
- die Zusatzschicht (40) die aktive Seite (34) des Halbleiterplättchens vollständig bedeckt mit Ausnahme der in der Draufsicht gezahnten Aussparungen (46) und
- die Zusatzschicht (40) eine höhere Stärke als das Halbleiterplättchen (32) aufweist.

2. Vorrichtung mit integrierten Schaltungen nach Anspruch 1, **dadurch gekennzeichnet, dass** die Stärke des Halbleiterplättchens (32) zwischen 5 und 50 µm liegt.

3. Vorrichtung mit integrierten Schaltungen nach Anspruch 2, **dadurch gekennzeichnet, dass** die Stärke der Zusatzschicht (40) zwischen 100 und 200 µm liegt.

4. Vorrichtung mit integrierten Schaltungen nach einem der Ansprüche 1 bis 3, **dadurch gekennzeichnet, dass** die Zusatzschicht (40) aus dem gleichen Halbleitermaterial wie das Halbleiterplättchen (32) gefertigt ist.

5. Elektronisches Chipkartenmodul mit:
- einem Halbleiterplättchen (32), das eine aktive Schicht bildet, in welcher die integrierten Schaltungen eingebracht sind, wobei das Halbleiterplättchen (32) eine aktive Seite (34) mit mehreren elektrischen Verbindungsstiften (36) und eine zweite Seite (38) umfasst.
- einer Zusatzschicht (40) mit einer ersten Seite (42), die auf der aktiven Seite (34) des Halbleiterplättchens (32) befestigt ist, einer zweiten Seite (44) und einer seitlichen Fläche (48), die den Umfang der Zusatzschicht bestimmt.
- einem Isolierträger (50) mit einer mit äußeren elektrischen Kontaktflächen (56) bestückten Außenseite (54) und einer Innenseite, wobei die zweite Seite (38) des Halbleiterplättchens (32) auf der Innenseite des Isolierträgers (50) befestigt ist, und:
- mehreren elektrischen Leitern (60), wobei ein erstes Ende jedes Leiters an einen Kontaktstift (36) und sein zweites Ende an eine äußere Kontaktfläche (56) angeschlossen ist, **dadurch gekennzeichnet, dass**:
- das Halbleiterplättchen (32) eine Stärke unter 100 µm besitzt.
- die Zusatzschicht (40) so viele in der Draufsicht gezahnte Aussparungen (46) umfasst, wie Kontaktstifte auf dem Halbleiterplättchen vorhanden sind, wobei jede Aussparung die ganze Stärke der Zusatzschicht (40) einnimmt und sich über das Volumen senkrecht über einem Kontaktstift (36) bis zur besagten seitlichen Fläche (48) erstreckt.
- die Zusatzschicht (40) die aktive Fläche (34) des Halbleiterplättchens vollständig bedeckt mit Ausnahme der in der Draufsicht gezahnten Aussparungen (46); dass
- die Zusatzschicht (40) eine höhere Stärke als das Halbleiterplättchen (32) aufweist, und dass
- jeder elektrische Leiter (60) vollständig zwischen der Ebene (P - P'), welche die zweite Seite (44) der Zusatzschicht (40) enthält, und dem Isolierträger (50) angeordnet ist.

6. Elektronisches Modul nach Anspruch 5, **dadurch gekennzeichnet, dass** der Isolierträger (50) Fenster (58) aufweist, wobei jedes Fenster (58) gegenüber einer äußeren elektrischen Kontaktfläche (56) angeordnet ist.

7. Herstellungsverfahren für eine Vorrichtung mit integrierten Schaltungen nach einem der Ansprüche 1 bis 4 mit folgenden Schritten:
- einem Befestigungsschritt, bei welchem die erste Seite (42) der Zusatzschicht auf der aktiven Seite (34) des Halbleiterplättchens (32) derart befestigt wird, dass jede Aussparung (46) der Zusatzschicht sich über das Volumen senkrecht über einem Kontaktstift (36) des Halbleiterplättchens (32) bis zur seitlichen Fläche (48) der Zusatzschicht erstreckt, wobei die Zusatzschicht so viele in der Draufsicht gezahnten Aussparungen besitzt wie Kontaktstifte auf dem Halbleiterplättchen vorhanden sind, und wobei die besagte Zusatzschicht (40) die aktive Fläche (34) des Halbleiterplättchen vollständig bedeckt mit Ausnahme der in der Draufsicht gezahnten Aussparungen, und
- einem Bearbeitungsschritt, bei welchem das Halbleiterplättchen (32) von seiner zweiten Seite (38) bearbeitet wird, um es auf eine Stärke unter 100 µm zu bringen.
